# EUROPÄISCHE PATENTSCHRIFT

(11) **EP 1 102 527 B1**
(45) Veröffentlichungstag und Bekanntmachung des Hinweises auf die Patenterteilung: **21.03.2007**
(21) Anmeldenummer: 00125186.7
(22) Anmeldetag: 20.11.2000
(51) Int. Cl.: H05K 9/00, H05K 7/14

(54) **Abschirmgehäuse mit ESD-Schutz**
Housing with ESD protection
Boîtier protégé contre les décharges électrostatiques

(30) Priorität: 22.11.1999 DE 19956184
(43) Veröffentlichungstag der Anmeldung: 23.05.2001
(73) Patentinhaber: iAd Gesellschaft für Informatik, Automatisierung und Datenverarbeitung mbH, 90613 Grosshabersdorf (DE)
(72) Erfinder: Hampel, Hermann, Dipl.-Ing., 90613 Grosshabersdorf (DE)
(74) Vertreter: Dreykorn-Lindner, Werner

(56) Entgegenhaltungen:
- DE-A- 3 313 970
- DE-A- 4 309 084
- DE-U- 8 903 217
- GB-A- 2 292 483
- US-A- 5 544 008
- US-A- 5 808 237
- PATENT ABSTRACTS OF JAPAN vol. 1996, no. 12, 26. Dezember 1996 (1996-12-26) & JP 08 206325 A (SANKYO KK), 13. August 1996 (1996-08-13)

## Beschreibung

Die Erfindung betrifft ein Abschirmgehäuse gemäß dem Oberbegriff des Patentanspruchs 1.

Zur Verbesserung der Abschirmung ist es bekannt, ein geschlossenes, aus Metall gefertigtes Gehäuse vorzusehen, welches an gegenüberliegenden Innenseiten Nuten aufweist, in welche die Leiterplatte eingeschoben werden kann. An zwei gegenüberliegenden Wänden der auf diese Weise gebildeten Flachbaugruppe befinden sich außen Führungsstege, welche in entsprechend geformten Nuten in einem Gestell oder in einem Aufhahmerahmen geführt sind. Werden in der gleichen Aufnahmevorrichtung sowohl ungeschirmte Leiterplatten wie auch geschirmte Flachbaugruppen vorstehend geschilderter Bauweise eingesetzt, so ergibt sich, daß bei einer gleichmäßigen Ausführung des Aufnahmerahmens die Leiterplatten unterschiedliche Abmessungen haben messen, je nachdem, ob sie in einem Abschirmgehäuse eingesetzt sind oder nicht. Bei der Leiterplattenherstellung haben sich jedoch bestimmte Normmaße herausgebildet, z.B. das sog. "Europakartenformat". Entsprechend diesen Normmaßen sind die Abstände zwischen den Leiterplattenführungsebenen in den Gestellen und Aufhahmerahmen bemessen. Eine Verkleinerung der verfügbaren Leiterplattenoberfläche gegenüber dem Normmaß ist auch deshalb unerwünscht, weil hierdurch die Aufnahmekapazität der Leiterplatte eingeschränkt wird.

Um ohne Abwandlung der Abmessungen der Gestelle oder Aufhahmerahmen Leiterplatten der sonst hierfür gebräuchlichen Größe in einem geschlossenen Schirmgehäuse einzusetzen ist es aus der DE 37 35 456 A1 bekannt, die Führungsmittel in der Aufnahmevorrichtung als Stege und die Führungsmittel am Schirmgehäuse als Nuten auszugestalten. Das Schirmgehäuse besteht aus Blech, wobei die Nuten durch Einprägungen gebildet sind. Im einzelnen sind in der Aufnahmevorrichtung zwei gegenüberliegende Führungsebenen vorgesehen, wobei die Führungsebenen aus Blech geformte Querträger sind und eine Mehrzahl von Stegen tragen, welche aus der Blechoberfläche freigestanzte und rechtwinkelig umgebogene Blechstreifen sind. Alternativ können auch Querträger mit jeweils nur einem Steg vorgesehen werden, welche als langgestreckte Blechwinkel ausgebildet sind, wobei ein Schenkel des Blechwinkels der Steg ist. Die Frontplatte ist an einem an der Vorderkante der Leiterplatte angebrachten Winkelblech befestigt und ist höher als das Schirmgehäuse selbst, so daß sie sowohl oben als auch unten über die Außenabmessungen des Schirmgehäuses hinausragt. Mit diesen überragenden Abschnitten der Frontplatte ist diese an der Vorderseite der Holme des Gestells in T-förmigen Nuten gehaltenen Gewindeschienen oder Schiebemuttern angeschraubt. Zwar lassen sich Einprägungen in Blechmaterial mittels numerisch gesteuerter Stanz- und Nibbelmaschinen mit hoher Genauigkeit schnell und kostengünstig erzeugen. Gleiches gilt für die parallelen Stege der Querträger, welche in einfacher Weise durch Freistanzen eines Blechstreifens und Umbiegen dieses Blechstreifens aus der Oberfläche den Querträgerbleches hergestellt werden können. Nachteilig ist jedoch, dass abhängig von der Bestückung der Leiterplatte bzw. für jedes Schirmgehäuse gesondert eine entsprechende Einstellung erfolgen muß und dass die Montage von Hohn, Querträger, Schirmgehäuse und Frontplatte eine Vielzahl von Handgriffen erfordert.

Um die Flexibilität in der Raumeinteilung im Innern des Abschirmgehäuses zu erhöhen und Leiterplatten unterschiedlichster Breite verwenden zu können, ist es aus der DE 37 32 885 C1 bekannt, zwischen den Leiterplatten angeordnete, in Führungsschienen eines metallischen Rahmens, welcher aus metallischen Abschirmplatten und diese verbindende Verbindungselemente besteht, eingeschobene Abschirmplatten selbst wieder als Führungen für Leiterplatten und Abschirmplatten zu nutzen. An den offenen Stirnseiten des Abschirmgehäuses sind Befestigungsausnehmungen für Schrauben od. dgl. zur Befestigung einer Frontplatte od. dgl. vorzusehen. Bei Ausführung des Abschirmgehäuses als Hohlprofil können die Befestigungsausnehmungen als Extrusionskanäle im Hohlprofil verwirklicht werden. An den Seiten der Verbindungselemente ist der Rahmen mit jeweils mindestens einer nach außen abragenden Führungsplatte versehen. Diese Führungsleisten können in Führungsschienen eines Racks eingeschoben werden. Das aus der DE 37 32 885 C1 bekannte Abschirmgehäuse weist den Nachteil auf, dass im Innern des Abschirmgehäuses entstehende Wärme nicht abgeführt werden kann.

Weiterhin ist aus der DE 198 21 522 C1 eine Schirmeinrichtung für einen Baugruppenträger zur Aufnahme von einschiebbaren elektrischen Baugruppen bekannt, bei der Schirmbleche zur elektromagnetischen Schirmung und Entwärmung der Baueinheit vorgesehen sind. Um die Schirmwirkung der Außenwand des Baugruppenträgers zu verbessern, weist die Außenwand zwei der gelochten Schirmbleche auf, die sich mit Abstand zumindest annähernd parallel zueinander erstrecken. Die Außenwand kann auch als separates Wandteil ausgebildet sein, wobei zumindest eines der Schirmbleche entlang der umlaufenden Ränder abgebogene Stege aufweist, die sich mit dem anderen Schirmblech überlappen und wobei die beiden Schirmbleche im Überlappungsbereich miteinander kontaktiert sind. Im einzelnen können die beiden im wesentlichen ebenen Schirmbleche z. B. durch eine U-förmige Biegung über einen gemeinsamen Verbindungssteg einstückig miteinander verbunden werden, wobei die überlappenden Stege entlang der restlichen Ränder ausgebildet sind. Auf einer der Frontseite abgewandten Rückseite des Baugruppenträgers ist eine Rückwandverdrahtungsplatte angeordnet und die beiden Schirmbleche weisen entlang der Rückseite die parallel zur Rückwandverdrahtungsplatte abgebogene sich überlappende Stege auf, an denen die Rückwandverdrahtungsplatte mittels schraubenartiger Verbindungselemente befestigt ist. Die Verbindungselemente sind durch die beiden rückseitigen Stege hindurchgeführt und verspannen die beiden Stege mit der Rückwandverdrahtungsplatte. Die aus der DE 198 21 522 C1 bekannte Schirmeinrichtung weist den Nachteil auf, dass der Montageaufwand relativ hoch ist und somit eine Automatisierung der Fertigung sehr aufwendig ist.

Aus dem DE 298 19 397 U1 ist ein Abschirmblech für einen Baugruppenträger - der zur Bestückung mit elektrischen Komponenten und vorzugsweise zum Einbau in einen Verteilerschrank bestimmt ist - bekannt, wobei ein oberes und/oder ein unteres metallischen Abschirmblech zwecks Abschirmung der vom Baugruppenträger getragenen elektrischen Komponenten gegen elektromagnetische Felder dazu bestimmt sind/ist, mit den metallischen Seitenwänden des Baugruppenträgers elektrisch leitend verbunden zu werden. Im einzelnen ist vorgesehen, dass das Abschirmblech an seinen den Seitenwänden des Baugruppenträgers benachbarten Rändern mit vorzugsweise rechtwinklig angewinkelten Laschen versehen ist, die mit Befestigungslöchern zur Befestigung an den Seitenwänden des Baugruppenträgers versehen sind. Die Befestigungslöchern sind als Gewindelöcher, als gewindefreie Einzüge oder als mit Gewinde versehene Einzüge ausgebildet und die Laschen sind an oder nahe den Stellen, an denen sie aus dem Abschirmblech hervortreten, mit einer Sollbruchstelle versehen.

Weiterhin ist aus der US 5 808 237 A ein Gehäuse zur Aufnahme elektronischer Baugruppen bekannt, dessen Bauweise die elektromagnetische Abstrahlung reduzieren soll. Das Gehäuse besteht aus zwei metallischen U-förmigen Gehäusewandungen (Chassis und Abdeckung) und einem weiteren Gehäuseteil, das in den Frontausschnitt einzusetzen ist und der Aufnahme von beispielsweise Laufwerken dient. Die beiden Gehäusewandungen werden mittels überlappender Falzen und darin integrierten Nuten bzw. Federn bei der Montage vorarretiert und dann beispielsweise verschraubt, wie es von einigen gängigen (Desktop-)PC-Modellen her bekannt ist. Der Einsatz von überlappenden Falzen mit integrierten Nuten/Federn dient dabei der Erhöhung der EMV-Dichtigkeit bei gleichzeitig angestrebter Erleichterung der Fertigung und Montage. Das Chassis enthält sowohl die Frontseite als auch die Rückseite, während die Abdeckung die beiden Seitenwände aufweist. Das in der US 5 808 237 A beschriebene Gehäuse ist für die Aufnahme eines kompletten Systems ausgelegt (mehrere Baugruppen, Stromversorgung, Einschübe...) und benötigt neben dem Chassis und der Abdeckung zusätzliche Frontplatten oder Einsätze für die Front- und/oder Rückseite (Stromversorgung = zusätzliches Gehäuse mit Frontplatte, Gehäuseschacht zur Aufnahme von Einschüben, Einschübe = Gehäuse mit Frontplatten oder ersatzweise nur Abdeckfrontplatten, Frontplatten für in das System einzusetzende Baugruppen (z.B. PC-Karten) oder ersatzweise nur Abdeckfrontplatten). Es sind also weitere Gehäuseteile (Frontplatten, ...) nötig, um die EMV-Dichtigkeit zu erzielen.

Weiterhin ist aus der DE 43 09 084 A1 ein störstrahlsicheres Gehäuse bekannt, wobei das Gehäuse zur Aufnahme einer Leiterplatte, aus zwei identischen U-förmigen Schalen und einem Frontdeckel besteht und welches nach hinten mit einer Rückwandleiterplatte abgeschlossen wird. Im einzelnen werden hierbei überlappende Falze beschrieben.

Weiterhin ist aus der DE 33 13 970 A1 eine Befestigungsvorrichtung zwischen zwei metallischen bzw. an den Innenseiten metallisierten Gehäuseteilen bekannt, die es erlaubt, die (leitenden) Ränder der beiden Gehäuseteile unter Druck aneinander liegen zu lassen und damit eine elektrische Verbindung herzustellen. Die jeweils mit einem Gehäuseteil verbundenen Befestigungselemente, welche die Verbindung per Kraft- oder Formschluss herstellen, können dabei gleichzeitig zur Fixierung der Leiterplatte(n) dienen. Im einzelnen sind hierzu zusammengehörige Paare von Befestigungselementen vorgesehen, die zu je einem Gehäuseteil gehören (im Beispiel eine Gewindebuchse und ein Durchgangsloch zur Aufnahme einer Zylinderkopfschraube) und per Kraft- oder Formschluss (z.B. durch Verschraubung) indirekt eine leitende Verbindung zwischen den beiden Gehäuseteilen herstellen, indem sie die leitenden Gehäuseränder aneinander drücken. Was die Fixierung einer Leiterplatte betrifft, so wird diese in der DE 33 13 970 A1 durch Druck auf gegenüberliegende Seiten der Leiterplattenoberfläche hergestellt, wozu eine Bohrung der Leiterplatte nötig ist, um jeweils ein Paar von Befestigungselementen der beiden Gehäuseteile, beispielsweise mittels Gewindebuchse und Schraube, miteinander zu verbinden.

Um ein Gehäuse anzugeben, das aus möglichst wenigen Teilen leicht zusammensetzbar ist, einfach und preisgünstig zu fertigen ist, eine wirkungsvolle Masseverbindung zur Leiterplatte und eine hohe Störstrahlsicherheit aufweist, ist schließlich aus der DE 89 03 217 U1 ein aus zwei Druckgussgehäuseteilen zusammensetzbares Gehäuse zur Aufnahme wenigstens einer Leiterplatte bekannt. Im Einzelnen ist ein erstes Gehäuseteil vorgesehen mit einer ersten Grundplatte mit Auflagemitteln für die Leiterplatte, mit einer an einem Rand angeformten Frontplatte und mit wenigstens einem angeschrägten Distanzsteg. Weiterhin ist ein zweites Gehäuseteil vorgesehen mit einer zweiten Grundplatte mit wenigstens einem an einem Rand angeformten in wenigstens eine Einsteckausnehmung der Frontplatte einsteckbaren Ansatz, mit Seitenwänden, mit einer Rückwand und mit mindestens einem entsprechend dem Distanzsteg der ersten Grundplatte angeschrägten Gegendistanzsteg. Das erste Gehäuseteil weist demnach zur Aufnahme der Leiterplatte sowie als Lötlinsenabdeckung die im wesentlichen ebene erste Grundplatte auf, die zur Auflage und Fixierung der Leiterplatte im Randbereich mit Auflagemitteln versehen ist. Die Ränder der Grundplatte sind an den Seiten und an der Rückseite hochgezogen, wobei der Rand an der Rückseite des Gehäuseteiles um einen in etwa der Höhe der Leiterplatte entsprechenden Absatz erniedrigt ist und eine Nut zur Aufnahme einer HF-Dichtschnur aufweist. Die Leiterplatte ist formmäßig an die vorbeschriebenen Kennzeichen des ersten Gehäuseteiles angepasst. So weist sie den Distanzsteg entsprechende Ausschnitte sowie zwei Bohrungen und eine mit einer Massefläche versehene Bohrung auf. Die zwei Bohrungen passen zu zwei auf den Auflagemitteln angeordneten Warzen. Eine der Bohrungen ist als Langloch ausgeführt, um Toleranzen des als Druckgussteil gefertigten ersten Gehäuseteils ausgleichen zu können. Durch die Bohrung ist eine Befestigungsschraube hindurchführbar und in einer im Bereich des Auflagemittels angeordneten Gewindebohrung verschraubbar und somit eine Masseverbindung herstellbar. Zur Arretierung der Leiterplatte sind an den Seitenwänden des zweiten Gehäuseteiles Stege vorgesehen, die bei geschlossenem Gehäuse gegen am Rand der Leiterplatte angeordnete Masseflächen drücken. Das zweite Gehäuseteil ist mit in die Seitenwände und in die zweite Grundplatte eingeprägten Gegendistanzstegen versehen, die entsprechend den Distanzstegen des ersten Gehäuseteiles angeschrägt sind und bei dem in der Figur gezeigten Ausführungsbeispiel Bohrungen aufweisen, durch die Schrauben hindurchführbar sind.

Wie die vorstehende Würdigung des Standes der Technik aufzeigt, wird bei Abschirmgehäusen häufig auf einstückige Gehäuse oder auf Gehäuse zurückgegriffen, welche aus einer Vielzahl von Einzelteilen zusammengebaut werden müssen oder es werden vormontierte komplette Systeme in ein Gehäuse eingesetzt, welches für die Aufnahme dieser Systeme speziell ausgestaltet werden muss.

Der Erfindung liegt die Aufgabe zugrunde, ein Abschirmgehäuse derart auszugestalten, dass eine kostengünstige Herstellung sowie eine einfache Montage ermöglicht wird.

Diese Aufgabe wird, ausgehend von einem Abschirmgehäuse mit den Merkmalen im Oberbegriff des Patentanspruchs 1 dadurch gelöst, dass in der Frontplatte mindestens eine Aussparung vorgesehen ist und dass ein dahinter angeordneter Block mindestens eine Führung für mindestens ein durch das Abschirmgehäuse hindurch betätigbares Befestigungsmittel zur Befestigung des Abschirmgehäuses in einem Rückwandbussystem aufweist, wodurch mittels Block ein zentrales Bezugspotential zur Verfügung steht und das Gehäuse sowohl EMV- als auch ESD-Anforderungen gerecht wird.

Gemäß Anspruch 1 ist das Gehäuse in Zweischalentechnik ausgeführt und besteht daher im Wesentlichen aus nur zwei Gehäuseteilen, in die bereits schon die Frontplatte integriert ist, was eine einfache Montage des Gehäuses möglich macht. Da die beiden Halbschalen metallisch (Stahlblech, verzinktes oder vernickeltes oder verchromtes Stahlblech oder Bleche aus Aluminium oder Kupfer) sind, dienen sie gleichzeitig als geerdete Schirmbleche, so dass keine zusätzliche Schirmung notwendig ist. Weiterhin ist von Vorteil, dass der Entsorgungsaufwand gering ist und dass eine leichte und kosteneffektive Anpassung an unterschiedliche Frontteile und Formate möglich ist. Insbesondere ist eine Anpassung an VME, VXI, CompactPCl und ähnliche Systeme bereits durch geringfügige Modifikationen durchführbar.

Die Verwendung von Metallblechen im Gegensatz zu metallisierten Kunststoffschalen bietet mehrere Vorteile. Einerseits erfordert die Herstellung der Schalen keine speziellen und teuren Gussformen, sondern die Bleche können CNC-gesteuert mit Hilfe eines Lasers zugeschnitten und mittels einer Biegemaschine zu den Halbschalen geformt werden, so dass nur geringe Herstellungskosten und Werkzeugkosten erforderlich sind. Dadurch wird auch eine schnelle und kosteneffektive Anpassung an unterschiedliche Frontteile und Formate möglich. Damit wird das Gehäuse auch für kleine und mittlere Serien rentabel, und ein schneller und kostengünstiger Bau von Mustern und Prototypen ("rapid prototyping") wird möglich. Des weiteren bietet die komplette Metallummantelung sehr gute EMV-Eigenschaften ebenso wie umweltgerechte Entsorgungsmöglichkeiten, da sie eine einfache Materialtrennung aller Montageteile erlaubt.

Die Baugruppe bzw. Leiterplatte ist gemäß Anspruch 1 bereits in einer Halbschale fest fixierbar mit Zugang zur Baugruppenseite (Bestückungsseite), was eventuelle Reparaturarbeiten und Bauteileaustausch auf der Platine erheblich erleichtert. Da die einzelne Halbschale mit der Baugruppe auch ohne die obere Gehäuseschale stabil im Abschirmgehäuse (Busgehäuse) untergebracht werden kann, wird auch die Konfiguration von Schaltern auf der Platine erheblich erleichtert.

Bei einer bevorzugten Ausgestaltung der Erfindung weisen, gemäß Patentanspruch 2, die beiden Halbschalen entlang der umlaufenden Ränder überlappende Falze auf oder die Schalenkanten stoßen ohne Überlappung aufeinander, wobei mindestens eine der beiden Halbschalen zwei Außenwände mit Löchern aufweist, die zur Belüftung und Entwärmung der Baugruppe dienen.

Ferner weist, gemäß einer Weiterbildung nach Patentanspruch 5, die Frontplatte Ausnehmungen und/oder Schlitze auf, in welche Erhebungen und/oder Zungen der anderen Halbschale einführbar sind.

Gemäß dieser Ausgestaltung bzw. Weiterbildung der Erfindung können die beiden Gehäuseschalen in zwei verschiedenen Ausführungen angefertigt werden. Bei der einen Ausführung besitzen die beiden Schalen entlang der umlaufenden Ränder überlappende Falzen, bei der anderen Ausführung stoßen sie ohne Überlappung aufeinander. Die Falze bieten mehrere Vorteile. Zum einen lassen sich die beiden Schalen bereits vor der Verschraubung gut miteinander arretieren und erhalten so eine höhere Stabilität. Zum anderen erhöhen sie die EMV-Dichtigkeit des Gehäuses an den Verbindungsstellen.

Vorzugsweise sind, gemäß Patentanspruch 4, die Lüftungslöcher im Wabenmuster mit einem Durchmesser von maximal 4mm ausgeführt, wodurch keine zusätzlichen EMV-Bleche oder überlappende Außenwände notwendig sind.

Durch die Anordnung der Lüftungslöcher im Wabenmuster wird im interessierenden Frequenzbereich ein Optimum zwischen Lüftung (schmale Stege) und EMV-Dichtigkeit erreicht. Falls größere Luftlöcher als in Anspruch 4 spezifiziert verwendet werden, können zusätzliche EMV-Bleche oder überlappende Außenwände der beiden Halbschalen angebracht werden, wie dies im Patentanspruch 3 beschrieben ist, um die EMV-Dichtigkeit wieder herzustellen.

Kunststoffhalteteile nach Patentanspruch 7 erhöhen die Positioniergenauigkeit und können auch im Ganzen metallisiert werden (falls keine Falze vorhanden sind), wodurch die EMV-Dichtigkeit an Verbindungsstellen weiter erhöht wird.

Gemäß Anspruch 8 ist im Gehäuse an zwei Stellen jeweils ein metallisierter Kunststoffblock angebracht der mehrere Funktionen erfüllt. Zum einen dient er zur Einhaltung des Rasterabstands, Aufnahme und Fixierung der Leiterplatte, als Führungsblock für Befestigungsschrauben der Kassette im Busgehäuse, Führung des Massekontaktes, EMV-Abschottung der Leiterplatte zur Blechkante (alternativ zum Falz) und den Luftlöchern, Fixierung der Blechrückwand. Des weiteren bildet er ein zentrales Bezugspotential gemäß Anspruch 9 und beinhaltet damit auch einen separat geführten ESD-Schutz, der es ermöglicht, dass elektrostatische Entladungen vorrangig über das Gehäuse abgeleitet werden. Die Erdungsbügel sind für alle Platinentypen einsetzbar, d.h. es sind keine unterschiedlichen Erdungsbügel notwendig.

Bei einer bevorzugten Ausgestaltung der Erfindung weisen, gemäß Patentanspruch 12, die beiden Halbschalen Senkungen und diese mittig eine Öffnung für Befestigungsmittel auf, wobei auf den Senkungen die Leiterplatte aufliegt.

Durch die Wahl der Senkungen bzw. Einprägungen können bei dieser bevorzugten Ausgestaltung der Erfindung Standardmontageteile verwendet werden, so dass keine teuren Sonderanfertigungen von Schrauben und Bolzen notwendig sind. Weiterhin ist von Vorteil, dass durch den Abstand zwischen Leiterplatte und Halbschale eine gute Wärmeabführung erreichbar ist. In Verbindung mit seitlicher Belüftung ist eine sehr gute Kühlung möglich.

Weitere Vorteile und Einzelheiten lassen sich der nachfolgenden Beschreibung von bevorzugten Ausführungsformen der Erfindung unter Bezugnahme auf die Zeichnung entnehmen. In der Zeichnung zeigt:
- FIG. 1: eine erste Ausführungsform des erfindungsgemäßen Abschirmgehäuses in Explosionsdarstellung,
- FIG. 2: die perspektivische Schnittdarstellung in Draufsicht auf das Abschirmgehäuse gemäß FIG. 1,
- FIG. 3: eine Ausführungsform der Rückwand in der Seitenansicht,
- FIG. 4: eine erste Ausgestaltung des Blocks in den Seitenansichten, teilweise im Schnitt,
- FIG. 5: eine zweite Ausgestaltung des Blocks in den Seitenansichten, teilweise im Schnitt,
- FIG. 6: die eine Halbschale ohne integrierter Frontplatte des erfindungsgemäßen Abschirmgehäuses in Draufsicht und in verschiedenen Seitenansichten,
- FIG. 7: die Frontplatte einer zur Halbschale der FIG. 6 korrespondierenden Halbschale und
- FIG. 8: die Halbschale gemäß FIG. 7 mit integrierter Frontplatte des erfindungsgemäßen Abschirmgehäuses in Draufsicht und in verschiedenen Seitenansichten,
- FIG. 9: die Halbschale gemäß FIG. 8, teilweise ohne an den Rändern angeordnete Falze sowie die Senkungen in der Halbschale in vergrößerter Darstellung,

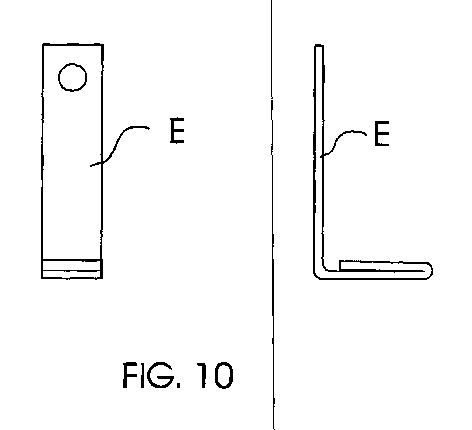

- FIG.10: eine Ausführungsform des Erdwinkels,
- FIG. 11: eine Ausführungsform für die Leiterplatte,
- FIG.12: für eine zweite Ausführungsform des erfindungsgemäßen Abschirmgehäuses (doppelte Bauhöhe bzw. Rasterabstand) eine erste Ausgestaltung des Blocks in den Seitenansichten, teilweise im Schnitt,
- FIG.13: eine zweite Ausgestaltung des Blocks nach FIG. 12 in den Seitenansichten, teilweise im Schnitt,
- FIG.14: die eine Halbschale mit integrierter Frontplatte für die zweite Ausführungsform des erfindungsgemäßen Abschirmgehäuses in Draufsicht und in verschiedenen Seitenansichten,
- FIG.15: die andere Halbschale ohne integrierter Frontplatte in Draufsicht und in verschiedenen Seitenansichten,
- FIG.16: für eine dritte Ausführungsform des erfindungsgemäßen Abschirmgehäuses (Aufnahme einer Baugruppe mit Frontblende) eine erste Ausgestaltung des Blocks in den Seitenansichten, teilweise im Schnitt,
- FIG.17: eine zweite Ausgestaltung des Blocks nach FIG. 16 in den Seitenansichten, teilweise im Schnitt,
- FIG.18: die eine Halbschale mit integrierter Teil-Frontplatte für die dritte Ausführungsform des erfindungsgemäßen Abschirmgehäuses in Draufsicht und in verschiedenen Seitenansichten und
- FIG.19: die andere Halbschale ohne integrierter Frontplatte in Draufsicht und in verschiedenen Seitenansichten.

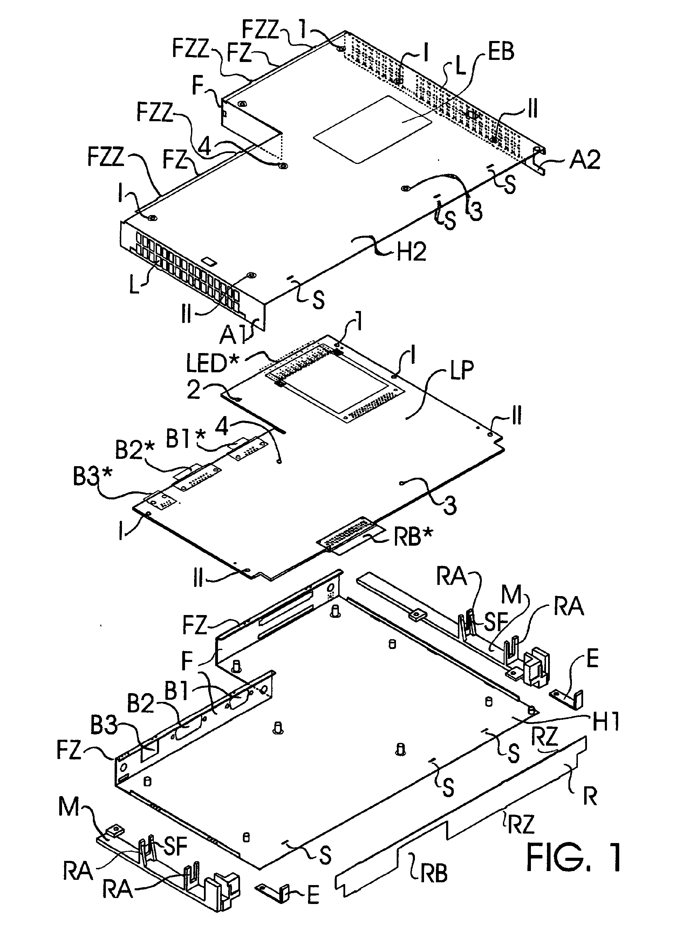

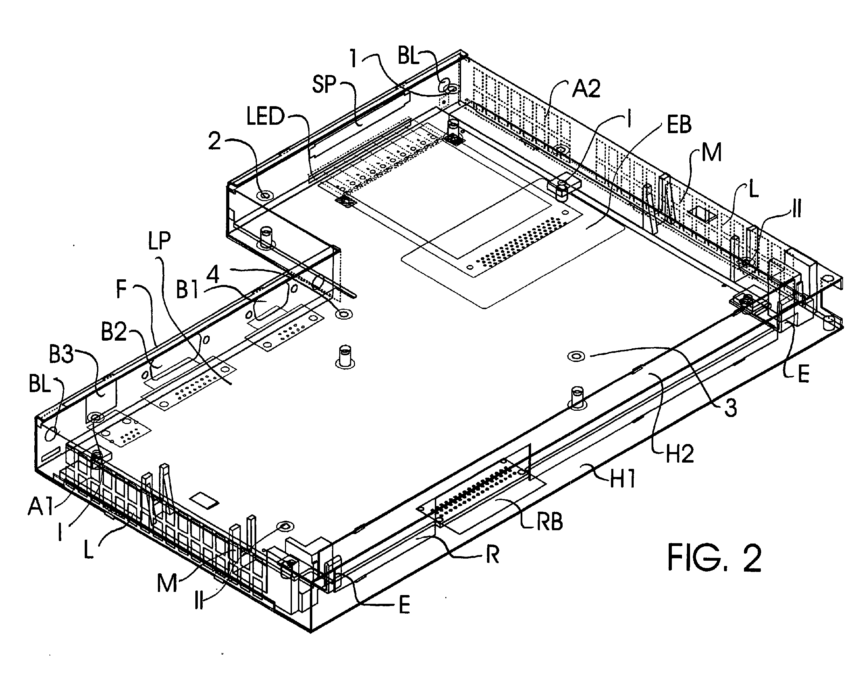

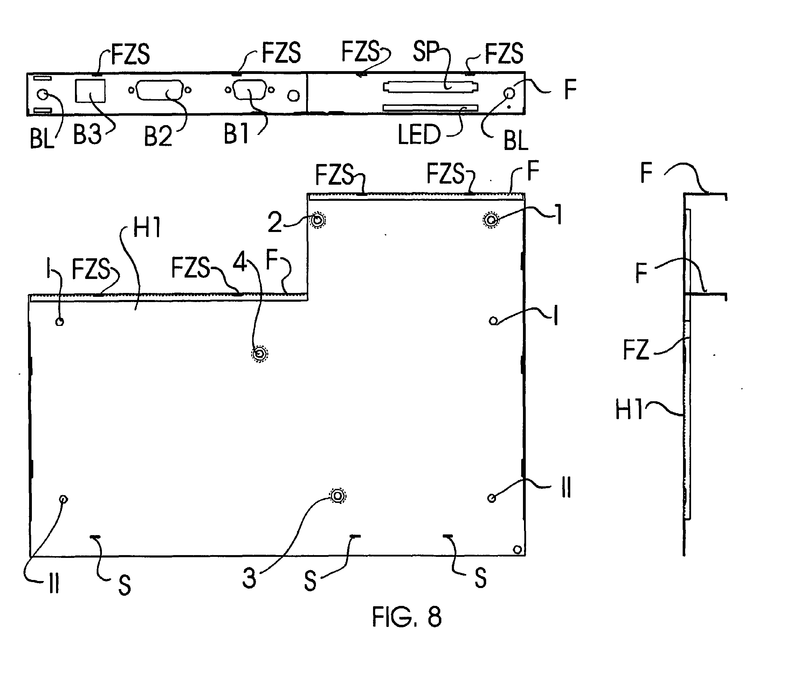

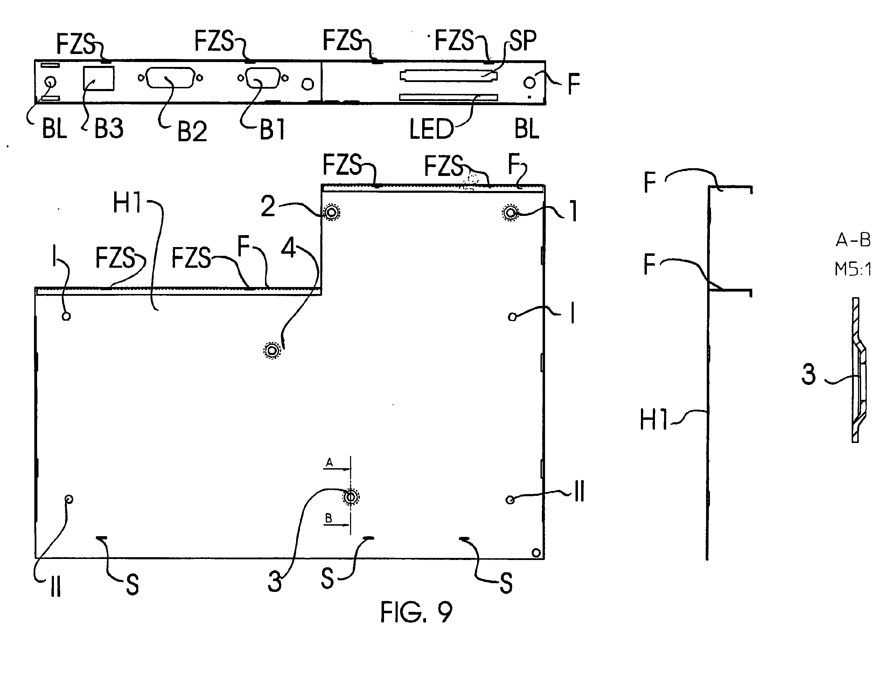

Die Erfindung wird im folgenden anhand einer Abschirmgehäuses für störempfindliche und emittierende elektronische Baugruppen in Rückwandbussystemen beschrieben, wobei das Abschirmgehäuse in Zweischalentechnik mit integrierter Frontplatte ausgeführt ist und welches auf der Gehäuseaußenseite (bis auf die Senkungen 1, 2, 3 und 4) lackiert werden kann. Prinzipiell ist das erfindungsgemäße Abschirmgehäuse für viele Anwendungsfälle geeignet, beispielsweise in allen digitalen Übertragungssystemen einsetzbar. Die Zeichnung, insbesondere FIG. 1 und FIG. 2 zeigen eine erste Ausführungsform des erfindungsgemäßen Abschirmgehäuses in Explosionsdarstellung bzw. in perspektivischer Schnittdarstellung zur Aufnahme einer bauteilbestückten Leiterplatte LP und/oder Baugruppe, welches metallische Gehäusewandungen aufweist. Erfindungsgemäß besteht das Gehäuse aus zwei Halbschalen H1, H2, wobei die eine Halbschale H1 mit integrierter Frontplatte F ausgeführt ist. Die Leiterplatte (Baugruppe) ist form- oder kraftschlüssig in einer Halbschale H1 derartig befestigt, dass das Abschirmgehäuse sowohl EMV- als auch ESDAnforderungen gerecht wird. Die beiden Halbschalen H1, H2 können entlang der umlaufenden Ränder überlappende Falze FZ aufweisen oder die Schalenkanten stoßen ohne Überlappung aufeinander (siehe im Vergleich FIG. 8 und FIG. 9).

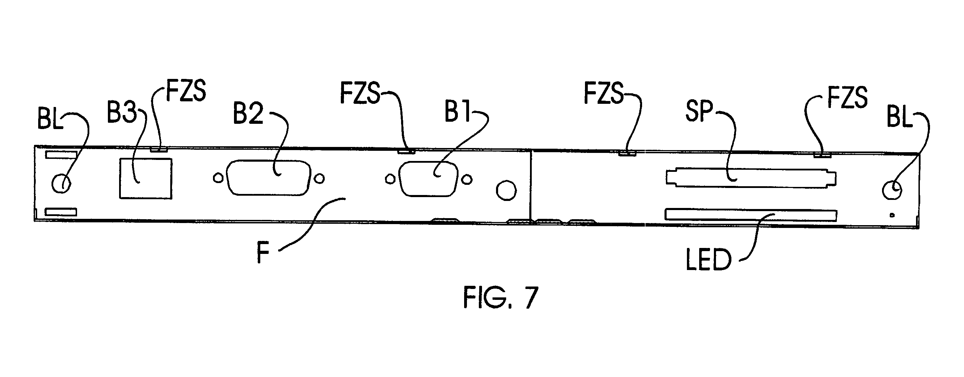

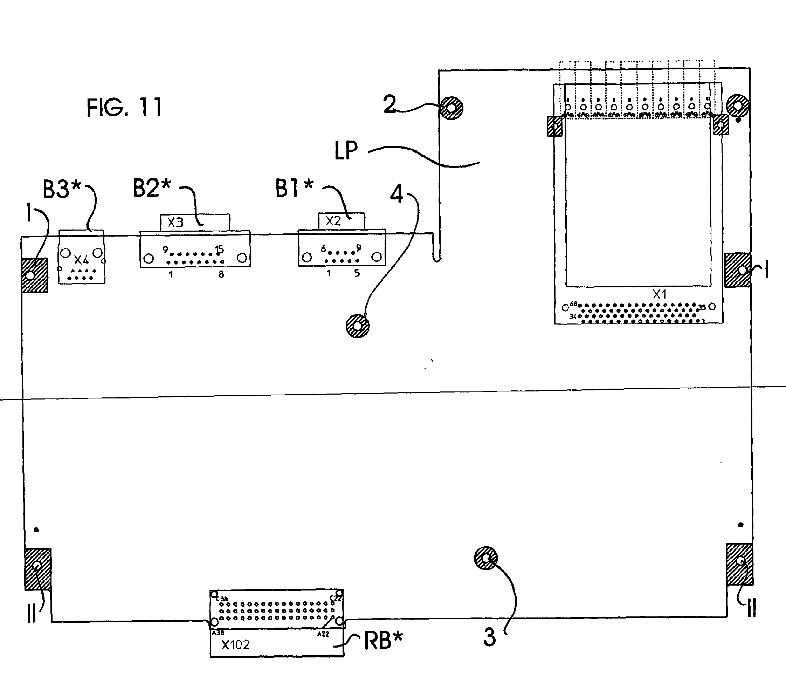

Weiterhin sind durch das Abschirmgehäuse hindurch betätigbare Befestigungsmittel zum Anschluss des Abschirmgehäuses an ein Rückwandbussystem vorgesehen. Im einzelnen ist in der Frontplatte F mindestens eine Aussparung BL vorgesehen und der dahinter angeordnete Block M weist mindestens eine Führung SF für mindestens ein durch das Abschirmgehäuse hindurch betätigbares Befestigungsmittel zur Befestigung des Abschirmgehäuses in einem Rückwandbussystem auf. Unterhalb der Aussparung BL kann auch eine Vertiefung von der Vorderseite eingeprägt werden, wie dies beispielsweise in FIG. 7 dargestellt ist. Eine galvanische Kopplung der Baugruppe mit anzuschließenden Frontelementen/externen Baugruppen kann über die Frontplatte F erfolgen. Hierzu ist vorgesehen, dass die Leiterplatte LP (eine Ausführungsform für die Leiterplatte LP ist in FIG. 11 dargestellt) oder eine in das Abschirmgehäuse von der Rückseite her einschiebbare Baugruppe mindestens eine Buchse trägt, beispielsweise eine SUBD9-Buchse B1*, eine SUBD15-Buchse B2* oder eine Ethernet-Buchse B3*, welche durch die jeweilige korrespondierende Ausnehmung B1, B2 oder B3 der Frontplatte F ragt und an dieser befestigt ist. Gleiches gilt für die Buchse RB* des Rückwandbussystems. Weitere Ausnehmungen in der Frontplatte F, wie beispielsweise die beiden Schlitze SP und LED (siehe FIG. 7 oder FIG. 8), dienen zum Einschieben einer PCMCIA-Speicherkarte oder einer LED-Anzeige bzw. Lichtleiter von der Frontseite her.

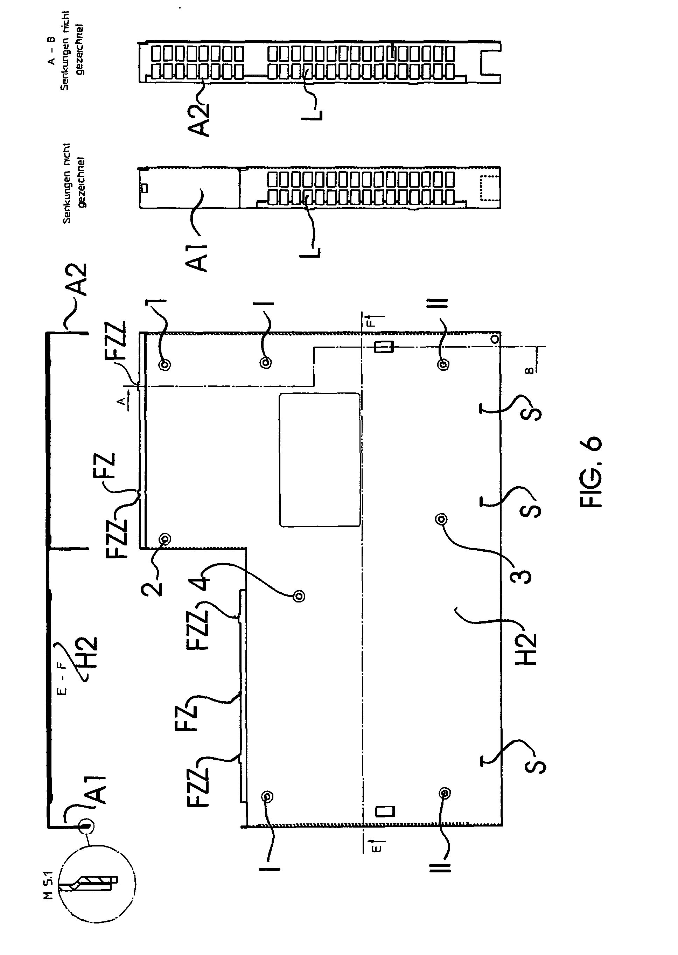

Bei einer bevorzugten Ausgestaltung ist vorgesehen, dass zumindest zwei Außenwände A1, A2 des Abschirmgehäuses Löcher L aufweisen, die zur Belüftung und Entwärmung der Baugruppe dienen (siehe beispielsweise FIG. 6). Parallel zu den beiden Außenwänden A1, A2, welche die Lüftungslöcher L enthalten, sind im Inneren des Gehäuses zusätzliche EMV-Bleche anbringbar; alternativ können auch überlappende Außenwände A1, A2 vorgesehen werden, die zur Kompensation der EMV-Undichtigkeit der Lüftungslöcher L dienen. Die Lüftungslöcher L können auch im Wabenmuster mit einem Durchmesser von maximal 4mm ausgeführt sein, wodurch für den interessierenden Frequenzbereich keine zusätzlichen EMV-Bleche mehr notwendig sind.

Bei einer bevorzugten Weiterbildung ist vorgesehen, dass an den Schienen des Rückwandbussystems zugewandten Außenwänden des Gehäuses Kunststoffhalteteile angebracht sind, die zur Führung des Abschirmgehäuses im Rückwandbussystems ausgelegt sind.

Im Inneren des Abschirmgehäuses an den beiden den Schienen des Rückwandbussystems zugewandten Außenwänden jeweils ein Metallblock oder ein metallisierter Kunststoffblock M angebracht ist, der zur Aufnahme und Fixierung der Leiterplatte dient und eine elektrische Verbindung zwischen Ober- und Unterschale H1, H2 des Gehäuses, der Leiterplatte und einem Erdwinkel E herstellt, wodurch ein zentrales Bezugspotential zur Verfügung steht.

Die Blöcke M sind beispielsweise aus Aluminium und als Schraubenführungen SF bei der Befestigung des Abschirmgehäuses im Rückwandbussystems ausgeführt und können vorzugsweise zur Führung des Massekontaktes E (Erdwinkels) ausgelegt sein. In Kombination hierzu können die beiden Halbschalen H1, H2 Senkungen 1, 2, 3, 4, I, II (beispielsweise hergestellt durch einprägen) mit einer mittig angeordneten Öffnung für Befestigungsmittel aufweisen, und auf den Senkungen 1, 2, 3, 4, I, II liegt die Leiterplatte LP auf. Beispielsweise kann jeweils ein der Senkung 1, 2, 3, 4, I, II räumlich zugeordneter, topfartiges und eine zentrale Bohrung aufweisendes Stützelement vorgesehen werden, in welche jeweils ein Verbindungsmittel zur Befestigung von Ober- und Unterschale H1, H2 des Gehäuses eintaucht. Alternativ können auch Einpress-Gewindebuchsen vorgesehen werden. Die in FIG. 11 dargestellten schraffierten Rechtecke (bei I, II) sind die Flächen für den ERDE-Anschluss und die schraffierten Kreise (bei 1, 2, 3, 4) kennzeichnen Sperrflächen ohne Bauteile und mit Durchkontaktierung der Bohrung sowie Leiterbahnen auf Aussenlagen.

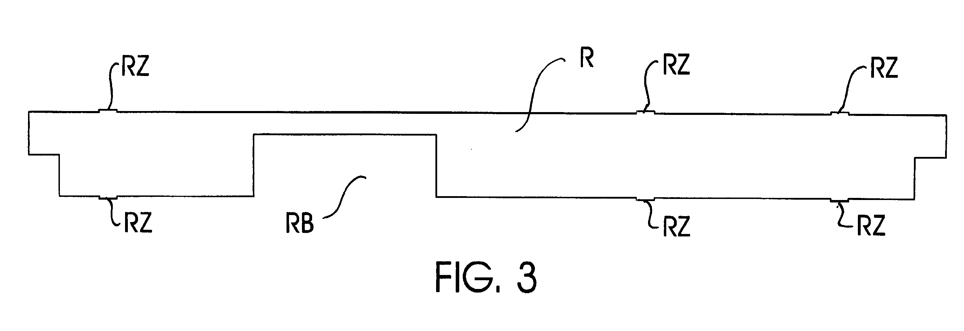

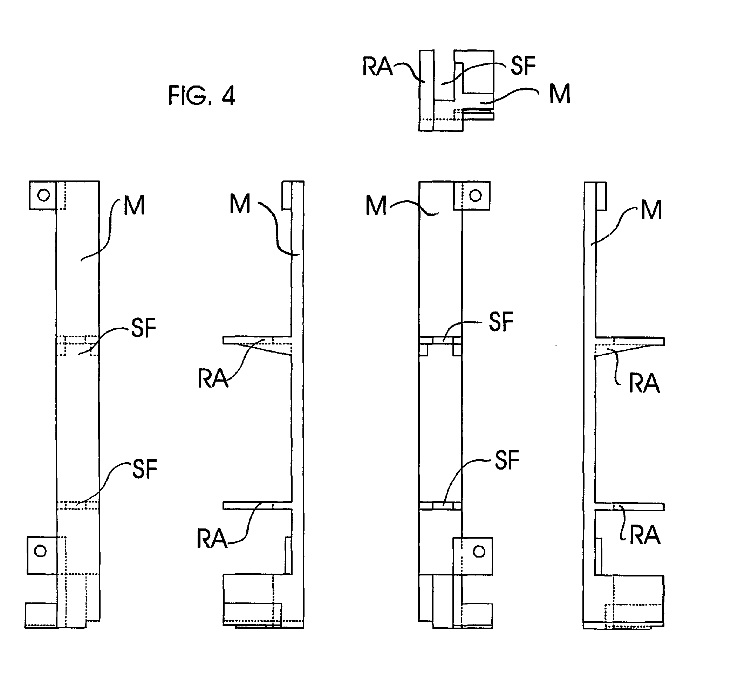

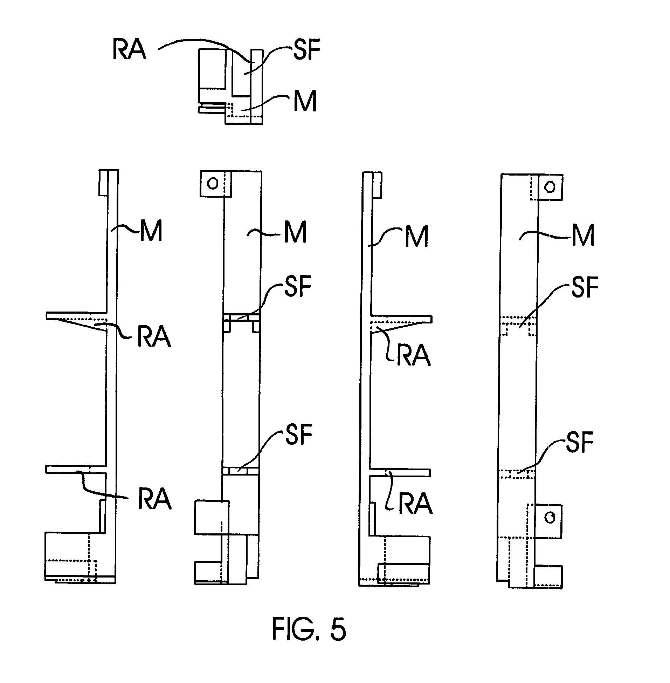

Die Blöcke M können weiterhin zur Fixierung der Rückwand R (Blechrückwand) und/oder zur Einhaltung des Rasterabstandes (vom Bussystem vorgegebenen Abstandes zwischen den beiden Gehäuseschalen) ausgestaltet sein. Vorzugsweise ist der Block M im wesentlichen L-förmig ausgestaltet und trägt zur Einhaltung des Rasterabstandes mindestens eine senkrecht aufragende Erhebung RA (siehe beispielsweise FIG. 4 und FIG. 5). Alternativ ist zur Fixierung die Rückwand R als im wesentlichen längliche Platte ausgestaltet, welche an den beiden Längsseiten Zungen RZ trägt, die in Schlitze S der beiden Halbschalen H1, H2 eingreifen (siehe FIG. 3).

Zwischen den Blöcken M und der Leiterplatte LP ist auf der Rückwandseite des Abschirmgehäuses jeweils ein metallischer Winkel E (Erdwinkel) angebracht, der das zentrale Bezugspotential des Gehäuses über Kontakte der Gehäuserückwand nach Außen (beispielsweise über Bolzen zum Einhängen aus Aluminium oder Edelstahl) führt. Im einzelnen ist vorgesehen, dass der im Inneren des Abschirmgehäuses an den beiden den Schienen des Rückwandbussystems zugewandten Außenwänden angebrachte Block M eine Nut oder einen Vorsprung zur Aufnahme und Fixierung der Leiterplatte LP aufweist, wobei in diesem Bereich der Leiterplatte LP eine Massefläche vorgesehen ist. An dieser Stelle ist zwischen den Blöcken M und der Leiterplatte LP auf der Rückwandseite des Abschirmgehäuses jeweils der metallische Winkel E angebracht, wodurch eine elektrische Verbindung zwischen den beiden Halbschalen H1, H2, der Leiterplatte LP und dem Erdwinkel E herstellt wird und ein zentrales Bezugspotential zur Verfügung steht.

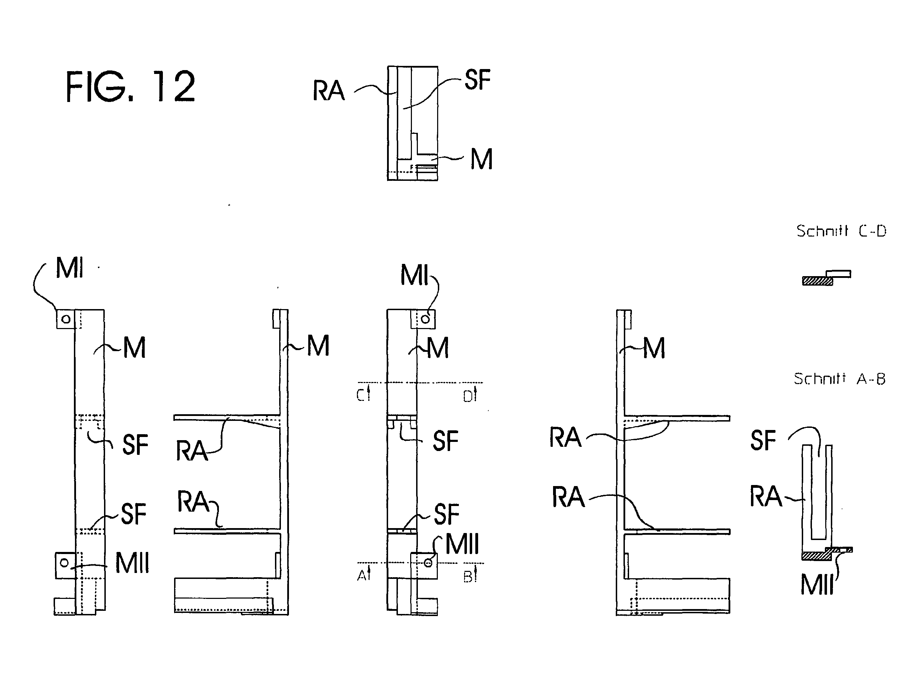

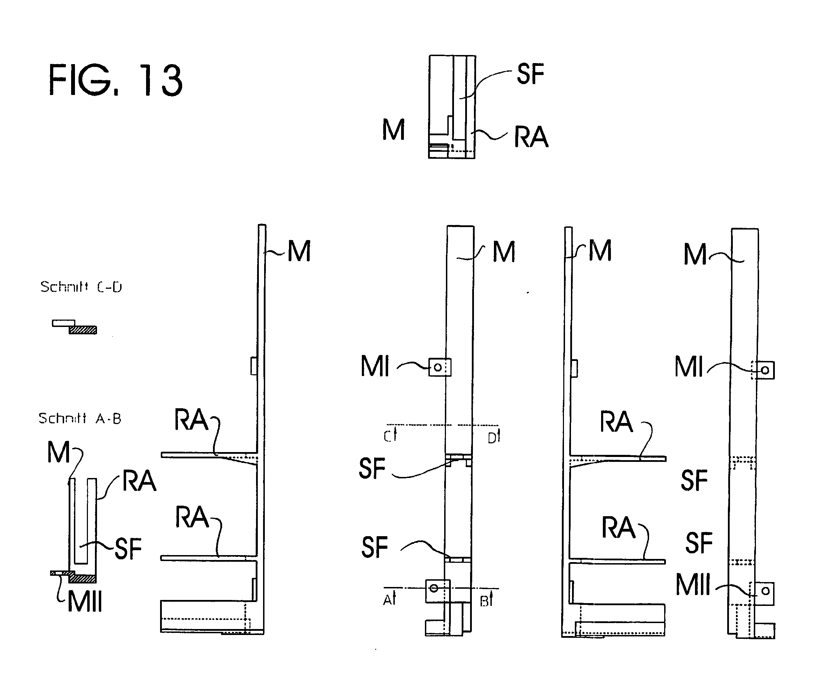

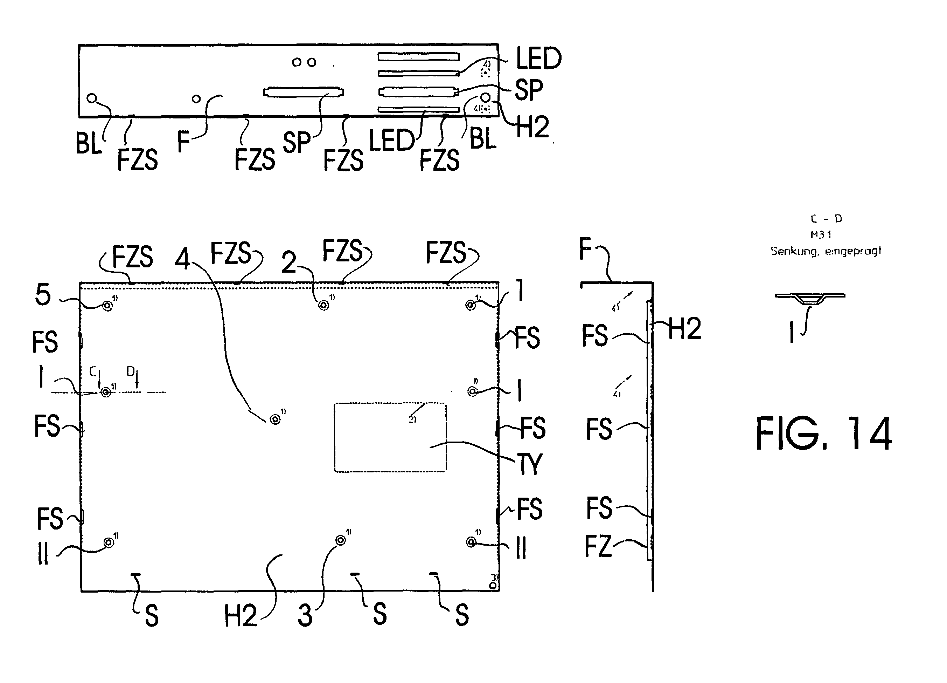

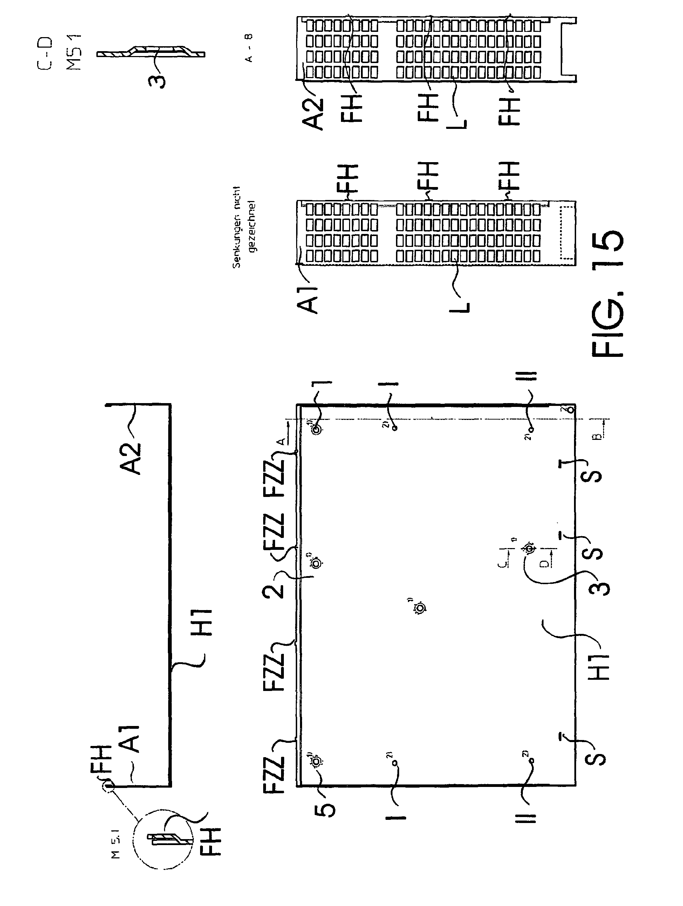

FIG. 12 bis 15 zeigen eine zweite Ausführungsform des erfindungsgemäßen Abschirmgehäuses für doppelte Bauhöhe bzw. Rasterabstand. Demzufolge sind die zwei Außenwände A1, A2 des Abschirmgehäuses sowie die Erhebungen RA doppelt so hoch. Die an der Massefläche der Leiterplatte LP aufliegenden Auskragungen des Blocks M sind mit MI und MII bezeichnet und weisen eine Bohrung für das Hindurchführen von Befestigungs- oder Führungsmitteln auf (siehe FIG. 12 und FIG. 13). Weiterhin ist bei dieser Ausführungsform die Frontplatte F in der L-förmigen Oberschale H2 integriert. Die Unterschale H1 ist U-förmig ausgestaltet und weist die beiden Außenwände A1, A2 auf. Zur Vereinfachung der Montage und Verbesserung des Abschirmverhaltens sind an den Außenwänden A1, A2 der Unterschale H1 Abkröpfungen FH vorgesehen, welche in korrespondierende Ausnehmungen FS der Oberschale H2 eingreifen (siehe FIG. 14 und FIG. 15). Schließlich weist die Oberschale H2 eine Senkung TY für das Anbringen eines Typenschildes auf.

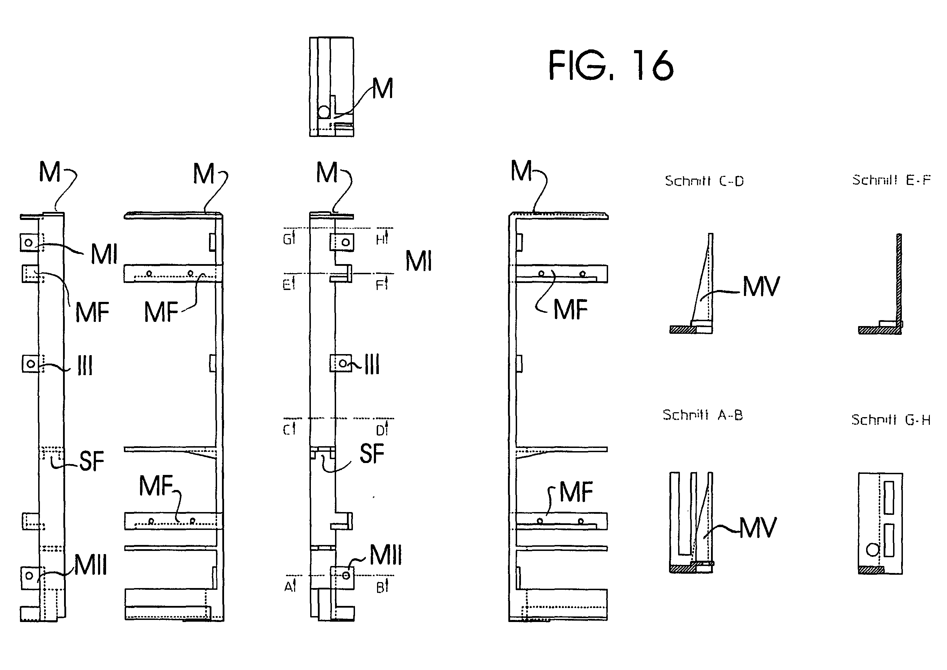

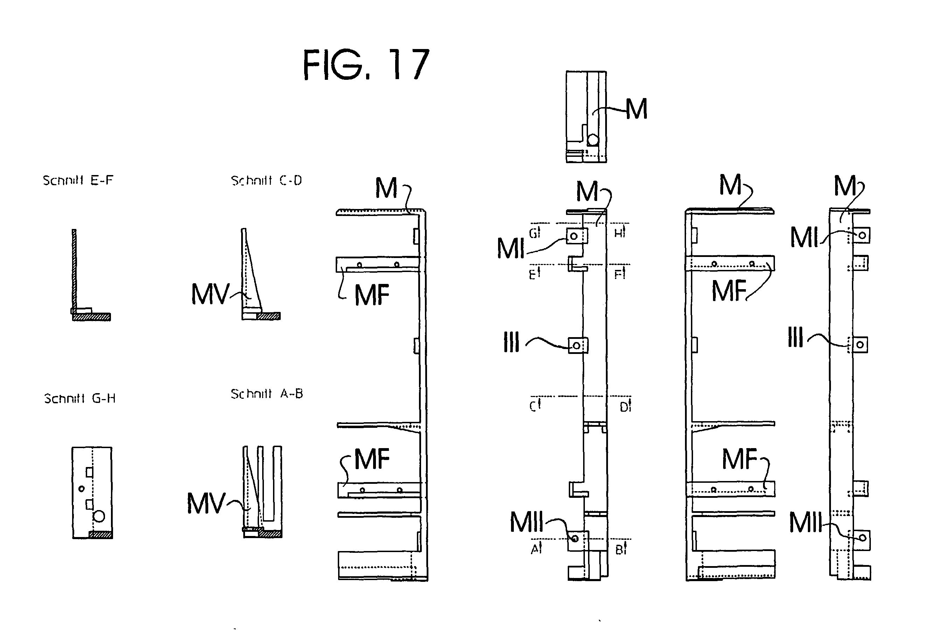

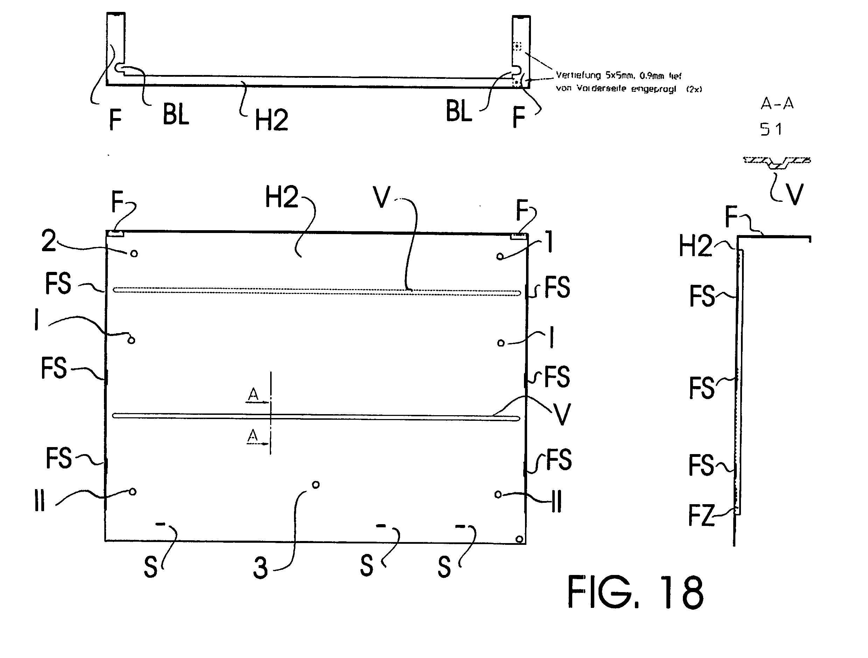

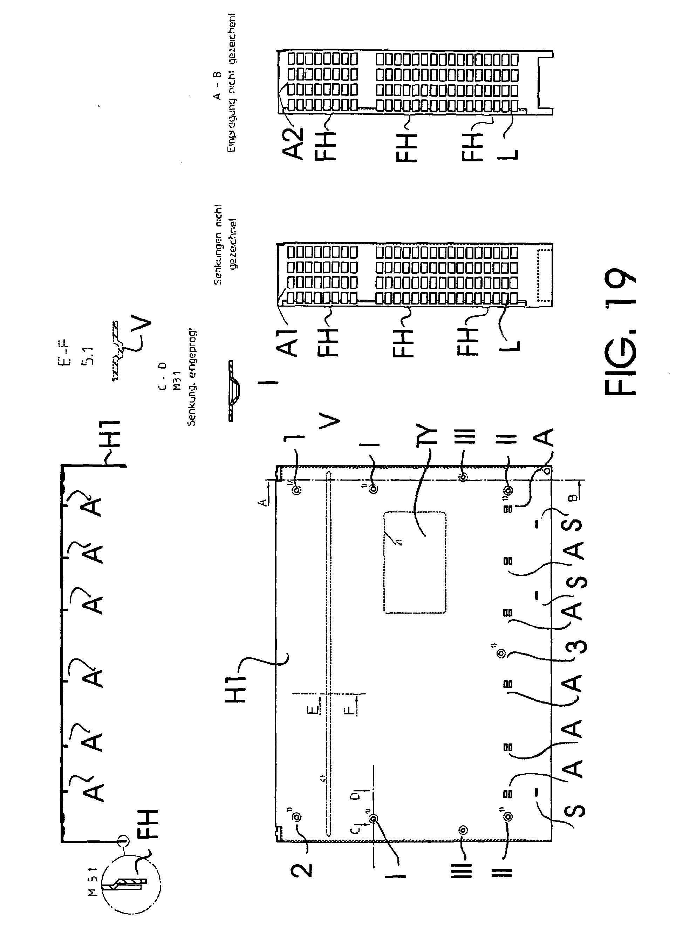

FIG 16 bis 19 zeigen eine dritte Ausführungsform des erfindungsgemäßen Abschirmgehäuses für die Aufnahme von Baugruppen mit einer frontseitigen Blende. Für den Block M ist auch weiterhin kein komplexer Fertigungsvorgang, insbesondere bei der Metallisierung, erforderlich, da diese für den gesamten Block M und auch ohne Maske erfolgen kann. Zusätzlich enthält der Block M für die Führung der Baugruppen vorzugsweise Führungsschienen MF (siehe FIG. 16 und FIG. 17) . Weiterhin sind zur Verbesserung der Stabilität Versteifungen MV bzw. Stabilität und/oder Kontaktierung Gewindebuchsen III vorgesehen. Schließlich weisen die Oberschale H2 und die Unterschale H1 Verstärkungen V in Form von Einprägungen oder Rippen zur Versteifung auf (siehe FIG. 18 und FIG. 19). Für den Fall der Aufnahme einer Baugruppe mit einer frontseitigen Blende kann die Oberschale H2 mit einer Teilfrontplatte F versehen werden und die Unterschale H1 weist nach innen umgebogene Ausstanzungen A auf, wie dies in FIG. 18 und FIG. 19 dargestellt ist. Alle dargestellten und beschriebenen Ausführungsmöglichkeiten, sowie alle in der Beschreibung und/oder der Zeichnung offenbarten neuen Einzelmerkmale und ihre Kombination untereinander, sind erfindungswesentlich. Beispielsweise kann an einer der beiden Halbschale seitlich eine Öffnung für einen Erweiterungsbus EB vorgesehen werden, die Blöcke M können eine im wesentlichen geschlossene Form im Bereich der Löcher L aufweisen; usw.

## Patentansprüche

1. Abschirmgehäuse zur Aufnahme mindestens einer bauteilbestückten Leiterplatte (LP), welches metallische Gehäusewandungen aufweist und aus zwei metallischen Halbschalen (H1, H2) besteht, wobei die eine Seite einer der beiden Halbschalen (H1) als Frontplatte (F) ausgeführt ist, und wobei im Inneren des Gehäuses mindestens ein Metallblock oder ein metallisierter Kunststoffblock angebracht ist, welcher zur Befestigung der Leiterplatte (LP) dient und welcher eine elektrische Verbindung zwischen den beiden Halbschalen (H1, H2) und der Leiterplatte (LP) herstellt, **dadurch gekennzeichnet, dass** in der Frontplatte (F) mindestens eine Aussparung (BL) vorgesehen ist und dass ein dahinter angeordneter Block (M) mindestens eine Führung (SF) für mindestens ein durch das Abschirmgehäuse hindurch betätigbares Befestigungsmittel zur Befestigung des Abschirmgehäuses in einem Rückwandbussystem aufweist, wodurch mittels Block (M) ein zentrales Bezugspotential zur Verfügung steht und das Gehäuse sowohl EMV- als auch ESD-Anforderungen gerecht wird.

2. Abschirmgehäuse nach Anspruch 1, **dadurch gekennzeichnet, dass** die beiden Halbschalen (H1, H2) entlang der umlaufenden Ränder überlappende Falze (FZ) aufweisen oder dass die Schalenkanten ohne Überlappung aufeinanderstoßen und dass mindestens eine der beiden Halbschalen (H1, H2) zwei Außenwände (A1, A2) mit Löchern (L) aufweisen, die zur Belüftung und Entwärmung der Baugruppe dienen.

3. Abschirmgehäuse nach Anspruch 2, **dadurch gekennzeichnet, dass** parallel zu den beiden Außenwänden (A1, A2), welche die Lüftungslöcher (L) enthalten, im Inneren des Gehäuses am Block (M) zusätzliche EMV-Bleche anbringbar sind oder dass beide Halbschalen (H1, H2) zwei sich jeweils überlappende Außenwände (A1, A2) mit Löchern (L) aufweisen, die zur Kompensation der EMV-Undichtigkeit der Lüftungslöcher (L) dienen.

4. Abschirmgehäuse nach Anspruch 2 oder 3, **dadurch gekennzeichnet, dass** die Lüftungslöcher (L) im Wabenmuster mit einem Durchmesser von maximal 4mm ausgeführt sind, wodurch keine zusätzlichen EMV-Bleche oder überlappende Außenwände (A1, A2) notwendig sind.

5. Abschirmgehäuse nach Anspruch 2, **dadurch gekennzeichnet, dass** die Frontplatte (F) Ausnehmungen und/oder Schlitze (FZS) aufweist, in welche Erhebungen und/oder Zungen (FZZ) der anderen Halbschale einführbar sind.

6. Abschirmgehäuse nach Anspruch 1, **dadurch gekennzeichnet, dass** die Leiterplatte (LP) oder eine in das Abschirmgehäuse von der Rückseite her einschiebbare Baugruppe mindestens eine Buchse (B1*) tragen, welche durch eine korrespondierende Ausnehmung (B1) der Frontplatte (F) ragt und an dieser befestigt ist, wodurch die galvanische Kopplung der Leiterplatte (LP) oder der Baugruppe mit anzuschließenden Frontelementen/externen Baugruppen über die Frontplatte (F) erfolgt.

7. Abschirmgehäuse nach Anspruch 1, **dadurch gekennzeichnet, dass** das Rückwandbussystem mindestens eine Halteschiene aufweist und das an der der Halteschiene zugewandten Rückwand (R) des Gehäuses Kunststoffhalteteile angebracht sind, die in die Halteschiene eingreifen und das Abschirmgehäuse in der Halteschiene führen.

8. Abschirmgehäuse nach Anspruch 1, **dadurch gekennzeichnet, dass** der im Inneren des Abschirmgehäuses an den beiden den Schienen des Rückwandbussystems zugewandten Außenwänden angebrachte Block (M) eine Nut oder einen Vorsprung zur Aufnahme und Fixierung der Leiterplatte (LP) aufweist, dass in diesem Bereich der Leiterplatte (LP) eine Massefläche vorgesehen ist und dass zwischen den Blöcken (M) und der Leiterplatte (LP) auf der Rückwandseite des Abschirmgehäuses jeweils ein metallischer Winkel (E, Erdwinkel) angebracht ist, wodurch eine elektrische Verbindung zwischen den beiden Halbschalen (H1, H2), der Leiterplatte (LP) und dem Erdwinkel (E) herstellt wird und ein zentrales Bezugspotential zur Verfügung steht.

9. Abschirmgehäuse nach Anspruch 1, **dadurch gekennzeichnet, dass** der Block (M) im wesentlichen L-förmig ausgestaltet ist und zur Einhaltung des Rasterabstandes (vom Bussystem vorgegebenen Abstandes zwischen den beiden Halbschalen) mindestens eine senkrecht aufragende Erhebung (RA) trägt.

10. Abschirmgehäuse nach Anspruch 7 und 8, **dadurch gekennzeichnet, dass** zwei Blöcke (M) vorgesehen sind, welche eine Führung für den Erdwinkel (E, Massekontakt) aufweisen und dass an den Blöcken (M) die Rückwand (R) befestigt ist.

11. Abschirmgehäuse nach Anspruch 7, **dadurch gekennzeichnet, dass** die Rückwand (R) als im wesentlichen längliche Platte ausgestaltet ist, welche an den beiden Längsseiten Zungen (RZ) trägt, die in Schlitze (S) der beiden Halbschalen (H1, H2) eingreifen.

12. Abschirmgehäuse nach Anspruch 1, **dadurch gekennzeichnet, dass** die beiden Halbschalen (H1, H2) Senkungen (1, 2, 3, 4, I, II) und diese mittig eine Öffnung für Befestigungsmittel aufweisen und dass auf den Senkungen (1, 2, 3, 4, I, II) die Leiterplatte (LP) aufliegt.

13. Abschirmgehäuse nach Anspruch 1, **dadurch gekennzeichnet, dass** die Frontplatte (F) in der Oberschale (H2) integriert ist, dass die Oberschale L-förmig (H2) und die Unterschale (H1) U-förmig ausgestaltet ist und dass zur Vereinfachung der Montage und Verbesserung des Abschirmverhaltens an den Seitenwänden (A1, A2) der Unterschale (H1) Abkröpfungen (FH) vorgesehen sind, welche in korrespondierende Ausnehmungen (FS) der Oberschale (H2) eingreifen.

14. Abschirmgehäuse nach Anspruch 1 oder 13, **dadurch gekennzeichnet, dass** zur Aufnahme von Baugruppen mit einer frontseitigen Blende, eine der beiden Halbschalen (H1, H2) eine Teil-Frontblende (F) aufweist und dass die beiden Halbschalen (H1, H2) mit Verstärkungen (V) in Form von Einprägungen oder Rippen versehen.

15. Abschirmgehäuse nach Anspruch 14, **dadurch gekennzeichnet, dass** der Block (M) für die Führung der Baugruppen Führungsmittel (MF) aufweist und dass zur Verbesserung der Stabilität Versteifungen (MV) und/oder Gewindebuchsen (III) vorgesehen sind.

16. Abschirmgehäuse nach Anspruch 14, **dadurch gekennzeichnet, dass** eine der beiden Halbschalen (H1, H2) nach innen umgebogene Ausstanzungen (A) aufweist.

## Claims

1. Shielding case for housing at least one printed circuit board (LP), which has metallic case walls and comprises two metallic half case bodies (H1, H2), wherein one side of one of said two half case bodies (H1) comprises a faceplate (F) and wherein within the shielding case at least one metallic block or one metallised plastic block is arranged for fixing said printed circuit board (LP) and electrically connecting said two half case bodies (H1, H2) with said printed circuit board (LP), **characterized in that** said faceplate (F) provides at least one recess (BL) and wherein a block (M) arranged behind said recess (BL) provides at least one guide (SF) for at least one fixing means operable through the shielding case for fastening the shielding case to a backplane bus system, wherein by means of said block (M) a central reference potential is provided and the shielding case corresponds to EMC (electromagnetic compatibility) and ESD (electrostatic discharge) requirements.

2. Shielding case according to claim 1, wherein said half case bodies (H1, H2) have overlapping lips (FZ) along their edges or wherein said half case bodies touch adjacently without overlapping and wherein at least one of said half case bodies (H1, H2) has two outer walls (A1, A2) with holes (L), which provide ventilation and heat extraction of the assembly.

3. Shielding case according to claim 2, wherein additional EMC-sheets can be mounted to said block (M) within said shielding case in parallel with said two outer walls (A1, A2) having ventilation holes (L) or wherein said half case bodies (H1, H2) comprise two each other overlapping outer walls (A1, A2) having holes (L), which provide a compensation of the EMC-leakage of the ventilation holes (L).

4. Shielding case according to claim 2 or 3, wherein said ventilation holes (L) are provided in a honeycomb pattern with a diameter of maximum 4 mm, by means of which no additional EMC-sheets or overlapping outer walls (A1, A2) shall be necessary.

5. Shielding case according to claim 2, wherein said faceplate (F) provides recesses and/or slots (FZS), in which protrusions and/or projection tongues (FZZ) of said other half case body can be inserted.

6. Shielding case according to claim 1, wherein said printed circuit board (LP) or an assembly of electronic components insertable from the backside of the shielding case at least provide one bushing (B1*), which projects out of a corresponding recess (B1) of said faceplate (F) and is mounted to it, whereby said printed circuit board (LP) or said assembly of electronic components is galvanically coupled with front elements/external assemblies via said faceplate (F).

7. Shielding case according to claim 1, wherein said backplane bus system provides at least one holding bar and wherein to said back wall (R) of said shielding case facing the holding bar plastic fastening devices are mounted, which being engaged within the holding bar and guided the screening case in the holding bar.

8. Shielding case according to claim 1, wherein said block (M) arranged within said shielding case and mounted to said two outer walls facing said holding bars of the backplane bus system provides a groove or a high spot for accepting and fixing said printed circuit board (LP), wherein in this area of said printed circuit board (LP) an ground plane is provided and wherein between said blocks (M) and said printed circuit board (LP) metallic brackets (E, earth bracket) are mounted to the back wall of the shielding case, by means of which an electrical connection between said two half case bodies (H1, H2), said printed circuit board (LP) and said earth bracket (E) is produced and a central reference potential is provided.

9. Shielding case according to claim 1, wherein said block (M) is essentially "L"-shaped and provides at least one vertically protruding high spot (RA) in order to grant a raster spacing (distance between said two half case bodies defined by the bus system).

10. Shielding case according to claim 7 and 8, wherein two blocks (M) are provided having a guide for said earth bracket (E, earth contact) and wherein said back wall (R) is mounted to said blocks (M).

11. Shielding case according to claim 7, wherein said back wall (R) is essentially formed like a long sheet, which provides on both longitudinal sides tongues (RZ), being engaged into said slots (S) of said half case bodies (H1, H2).

12. Shielding case according to claim 1, wherein said half case bodies (H1, H2) provide dimples (1, 2, 3, 4, I, II) having concentric cuttings for fixing means and wherein said printed circuit board (LP) lies adjacently on said dimples (1, 2, 3, 4, I, II).

13. Shielding case according to claim 1, wherein said faceplate (F) is integrated in the top case body (H2), wherein said top case body (H2) is "L"-shaped and the bottom case body (H1) is "U"-shaped and wherein to facilitate the installation and improving the protection capability of said side walls (A1, A2) of the bottom case body (H1) bent sections (FH) are provided, engaging into corresponding recesses (FS) of the top case body (H2).

14. Shielding case according to claim 1 or 13, wherein one of said two half case bodies (H1, H2) provides a portion of that faceplate (F) for the acceptance of assemblies having a faceplate and wherein said two half case bodies (H1, H2) have reinforcements (V) in form of impressions or ribs.

15. Shielding case according to claim 14, wherein said block (M) provides guiding means (MF) for guiding said assemblies and wherein reinforcements (MV) and/or threaded bushings (III) are provided for improving the stability.

16. Shielding case according to claim 14, wherein one of said half case bodies (H1, H2) provides punched out portions (A) being bended inwards.

## Revendications

1. Boîtier de protection pour contenir au moins d'un circuit imprimé équipé des composants ayant des parois métalliques et étant composé de deux moitiés de boîtier métalliques (H1, H2), où un coté d'une de deux moitiés (H1) est formé comme front du boîtier (F) et où on a installé à l'intérieur du boîtier au moins un bloc métallique ou un bloc en plastique métallisé servant pour la fixation du circuit imprimé (LP) et réalisant une connexion électrique entre les deux moitiés (H1, H2) de boîtier et le circuit imprimé (LP), est **caractérisé en ce qu'**il y a dans le front de boîtier (F) au moins une ouverture (BL) et qu'un bloc (M) étant placé derrière le front de boîtier possède au moins un guidage (SF) pour au moins un moyen de fixation étant manipulé à travers le boîtier de protection pour la fixation de ce boîtier à un bus de fond de panier, assurant à l'aide du bloc (M) un potentiel électrique de référence central et le boîtier assure des demandes de protection d'immunité EMV de la compatibilité électromagnétique ainsi que des demandes de protection contre les DES (décharges électrostatiques).

2. Boîtier de protection selon revendication 1, **caractérisé en ce que** les deux moitiés (H1, H2) de boîtier possèdent autours de leurs bords une feuillure imbriquée (FZ) ou que les bords se touchent sans imbrication et qu'au moins une de deux moitiés (H1, H2) possède des parois (A1, A2) avec des trous (L) servant de l'aération et de réfrigération du module.

3. Boîtier de protection selon revendication 2, **caractérisé en ce qu'**en parallèle aux deux parois (A1, A2) contenant les trous de l'aération (L) on peut fixer à l'intérieur du boîtier au bloc (M) des tôles de compatibilité électromagnétique complémentaires ou que toutes les deux moitiés (H1, H2) possèdent respectivement deux parois (A1, A2) étant imbriquées avec des trous (L), servant de compensation de la perméabilité d'immunité EMV de la compatibilité électromagnétique des trous d'aération (L).

4. Boîtier de protection selon revendications 2 ou 3, **caractérisé en ce que** les trous (L) sont effectués d'une forme d'alvéole avec un diamètre maximal de 4 mm, ne nécessitant pas de tôles complémentaires d'immunité EMV de la compatibilité électromagnétique ou de parois (A1, A2) imbriquées.

5. Boîtier de protection selon revendication 2, **caractérisé en ce que** le front de boîtier (F) possède des ouvertures et/ou des fentes (FZS) dans lesquelles entrent des bosses et/ou des languettes (FZZ) de l'autre moitié de boîtier.

6. Boîtier de protection selon revendication 1, **caractérisé en ce que** le circuit imprimé (LP) ou un module qu'on peut introduire de la partie arrière dans le boîtier de protection, portent au moins une fiche de connexion (B1*) laquelle passe par une ouverture correspondante (B1) du front de boîtier (F) et étant fixée à celle-la, à l'aide de ça la connexion galvanique du circuit imprimé (LP) ou du module avec des éléments de front/des modules externes en passant par le front de boîtier s'effectue.

7. Boîtier de protection selon revendication 1, **caractérisé en ce que** le bus de fond de panier possède au moins un rail de connexion et que des pièces en plastique sont fixées à la paroi arrière (R) en face du rail de connexion, lesquelles entrent dans le rail de connexion et lesquelles guident le boîtier de protection dans les rails de connexion.

8. Boîtier de protection selon revendication 1, **caractérisé en ce que** le bloc (M) étant fixé à l'intérieur du boîtier de protection aux deux parois en face de deux rails du bus de fond de panier possède une rainure ou une saillie pour la réception et la fixation du circuit imprimé (LP), qu'on a prévu une surface de masse dans cette partie du circuit imprimé (LP) et que respectivement un équerre métallique (E, équerre de mise à la terre) est fixé entre les blocs (M) et le circuit imprimé (LP) à la paroi arrière du boîtier de protection, à l'aide de ça une connexion électrique entre les deux moitiés de boîtier (H1, H2), le circuit imprimé (LP) et l'équerre de mise à la terre est réalisée et un potentiel électrique de référence central est disponible.

9. Boîtier de protection selon revendication 1, **caractérisé en ce que** le bloc (M) a en général une forme d'un L et pour garantir une distance de quadrillage (étant demandé du bus de fond de panier et étant la distance entre les deux moitiés du boîtier) porte au moins une butée verticale (RA).

10. Boîtier de protection selon revendications 7 et 8, **caractérisé en ce que** deux blocs (M) sont prévus possédant un guidage pour l'équerre de mis à la terre (E, contact de la masse) et que la paroi arrière (R) est fixée aux blocs (M).

11. Boîtier de protection selon revendication 7, **caractérisé en ce que** la paroi arrière (R) a en général la forme d'une plaque oblongue, laquelle porte aux deux cotés lateraux des languettes (RZ), entrant dans des fentes (S) de deux moitiés du boîtier (H1, H2).

12. Boîtier de protection selon revendication 1, **caractérisé en ce que** les deux moitiés du boîtier (H1, H2) possèdent des dépressions (1, 2, 3, 4, I, II) ayant au milieu une ouverture pour des moyens de fixation et que le circuit imprimé (LP) est placé sur les dépressions (1, 2, 3, 4, I, II).

13. Boîtier de protection selon revendication 1, **caractérisé en ce que** le front de boîtier (F) est intégré dans la moitié de boîtier supérieure (H2), que la moitié de boîtier supérieure (H2) a la forme d'un L et la moitié de boîtier inférieure a la forme d'un U et que pour la simplification du montage et pour l'amélioration du comportement de blindage on a prévu aux parois latérales (A1, A2) de la moitié de boîtier inférieure (H1) des coudes (FH) lesquels entrent dans des ouvertures (FS) de la moitié de boîtier supérieure (H2).

14. Boîtier de protection selon revendications 1 ou 13, **caractérisé en ce que** pour la réception des modules avec une plaque frontale, une de deux moitiés de boîtier (H1, H2) possède un segment de front de boîtier et que les deux moitiés de boîtier sont équipées d'un renforcement (V) en forme des dépression estampées ou des nervures.

15. Boîtier de protection selon revendication 14, **caractérisé en ce que** le bloc (M) pour le guidage des modules possède des moyens de guidage (MF) et que pour l'amélioration de la stabilité des pièces de renforcement (MV) et/ou des douilles filetées (III) sont prévues.

16. Boîtier de protection selon revendication 14, **caractérisé en ce qu'**une de deux moitiés de boîtier (H1, H2) possède des découpages (A) coudés vers l'intérieur.
